(19) **Europäisches Patentamt**
**European Patent Office**
**Office européen des brevets**

(11) **EP 4 730 947 A1**

(12) **EUROPEAN PATENT APPLICATION**

(43) Date of publication:
**22.04.2026 Bulletin 2026/17**

(21) Application number: **25205935.7**

(22) Date of filing: **01.10.2025**

(51) International Patent Classification (IPC):
**H10D 1/00** $^{(2025.01)}$    **H10D 1/47** $^{(2025.01)}$
**H10D 84/00** $^{(2025.01)}$

(52) Cooperative Patent Classification (CPC):
**H10D 1/021; H10D 1/47; H10D 84/209**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.10.2024  US 202418920766**

(71) Applicant: **Avago Technologies International
Sales
Pte. Limited
Singapore 768923 (SG)**

(72) Inventors:
• **Kwan, Tom W.**
  **Cupertino, CA, 95014 (US)**
• **Mehr, Iuri**
  **Irvine, CA, 92618 (US)**

• **Wei, Guo Wen**
  **Saratoga, CA, 95070 (US)**
• **Su, Feng**
  **San Jose, CA, 95132 (US)**
• **Bhamra, Hansraj Singh**
  **San Jose, CA, 95132 (US)**
• **Mehta, Harsh**
  **Mountain View, CA, 94043 (US)**
• **Lin, Fang**
  **Cupertino, CA, 95014 (US)**
• **Desrosiers, Ryan**
  **Fort Collins, CO, 80528 (US)**

(74) Representative: **Grünecker Patent- und
Rechtsanwälte
PartG mbB
Leopoldstraße 4
80802 München (DE)**

(54) **RESISTOR WITH ACTIVE SHIELD IN A SEMICONDUCTOR DEVICE**

(57)    An example integrated circuit (IC) includes a semiconductor substrate having a first well and a second well; a first resistor disposed on the semiconductor substrate over the first well within a boundary thereof; a second resistor disposed on the semiconductor substrate over the second well within a boundary thereof, the boundary of the second well disjoint from the boundary of the first well; and a first contact to bias the semiconductor substrate at a first voltage, a second contact to bias the first well at a second voltage, and a third contact to bias the second well at a third voltage.

FIG. 3

**Description**

BACKGROUND

Polysilicon resistors in semiconductor devices, such as integrated circuits (ICs), can be resistive components made from polycrystalline silicon. Polysilicon resistors can be used due to their compatibility with standard complementary metal oxide semiconductor (CMOS) processes, stability, and ease of integration. A polysilicon resistor can be formed by depositing a thin film of polysilicon on a substrate, with its resistance value controlled by adjusting the length, width, thickness, and doping level of the polysilicon. Polysilicon resistors can be used in analog and mixed-signal circuits for applications like voltage dividers, biasing networks, and load resistors.

A polysilicon resistor can rest on a substrate that is biased at a voltage (Vsub). The substrate bias voltage (Vsub) can be independent of the resistor's two terminal voltages (V1, V2). A large voltage applied between V1 and Vsub, V2 and Vsub, or both can give rise to unwanted harmonic distortion in circuits using such a resistor.

SUMMARY

In an embodiment, an integrated circuit (IC) is described. The IC can include a semiconductor substrate having a first well and a second well. The IC can include a first resistor disposed on the semiconductor substrate over the first well within a boundary thereof. The IC can include a second resistor disposed on the semiconductor substrate over the second well within a boundary thereof. The boundary of the second well can be disjoint from the boundary of the first well. The IC can include a first contact to bias the semiconductor substrate at a first voltage, a second contact to bias the first well at a second voltage, and a third contact to bias the second well at a third voltage.

In another embodiment, an apparatus can include a first circuit having an input and an output. The apparatus can include a resistance disposed on a semiconductor substrate, the resistance comprising first resistors coupled in series between the input and the output of the first circuit. The apparatus can include first wells disposed in the semiconductor substrate, each first resistor disposed within a boundary of a respective one of the first wells. The boundaries of the first wells can be disjoint from one another. The apparatus can include a second circuit configured to generate bias voltages and couple each bias voltage to a respective one of the first wells.

In another embodiment, a method of fabricating an IC is described. The method can include forming a semiconductor substrate having a first well and a second well. The method can include forming a first resistor on the semiconductor substrate over the first well within a boundary thereof. The method can include forming a second resistor on the semiconductor substrate over the second well within a boundary thereof. The boundary of the second well can be disjoint from the boundary of the first well. The method can include forming a first contact to bias the semiconductor substrate at a first voltage, a second contact to bias the first well at a second voltage, and a third contact to bias the second well at a third voltage.

BRIEF DESCRIPTION OF THE DRAWINGS

Fig. 1 is a cross-sectional view of a resistor of an integrated circuit (IC).
Fig. 2 is a schematic diagram depicting a circuit that can be formed on a semiconductor substrate.
Fig. 3 is a cross-sectional view of resistors according to some embodiments.
Fig. 4 is a schematic diagram of a circuit that can be formed on a semiconductor substrate according to some embodiments.
Fig. 5 is a graph qualitatively depicting voltages in circuit according to some embodiments.
Fig. 6 is a schematic diagram depicting a circuit that can be formed on a semiconductor substrate according to some embodiments.
Fig. 7 is a flow diagram depicting a method of biasing polysilicon resistors on an IC with individual shields according to some embodiments.
Fig. 8 is a flow diagram depicting a method of fabricating polysilicon resistors of an IC according to some embodiments.

DETAILED DESCRIPTION

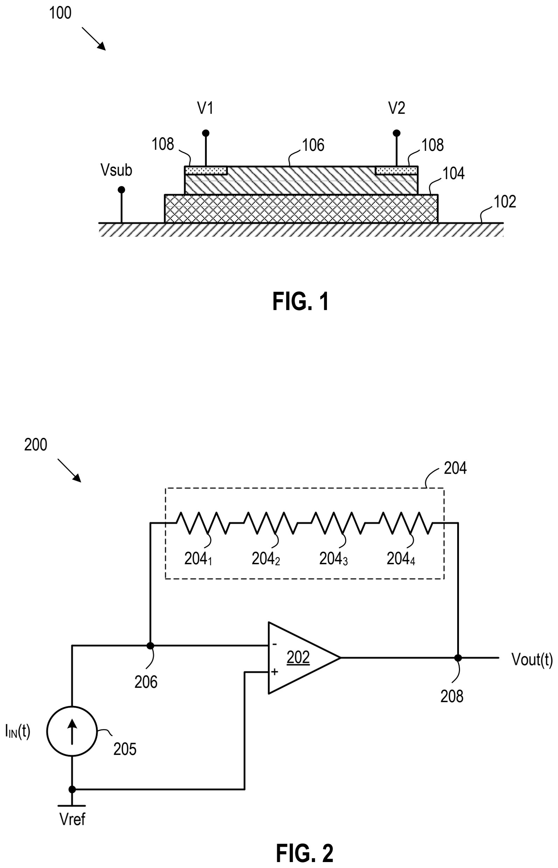

Fig. 1 is a cross-sectional view of a resistor 100 of an integrated circuit (IC). A circuit may be an interconnection of electrical components that includes closed loop(s) for the flow of electrical current. An electrical component may be a device that affects electrons or their associated electrical fields. An IC may be circuit(s) formed on a semiconductor substrate. A semiconductor substrate may be a support formed of semiconductor material. Semiconductor material may be material that exhibits semi-conductivity (e.g., conductivity between that of a metal and an insulator). An IC can include patterned conductive layers and dielectric layers disposed on the semiconductor substrate. Fig. 1 shows a cross-section of such an IC, namely, a portion of an IC comprising a resistor.

Resistor 100 includes a polysilicon layer 106 disposed on a dielectric layer 104, which is disposed on a semiconductor substrate 102. Polysilicon may be polycrystalline silicon. A dielectric may be an insulating material. Semiconductor substrate 102 can be formed of various semiconductor materials known in the art. One skilled in the art can select among known semiconductor materials based on the description of the examples and embodiments herein. Silicon is a widely used and well-known semiconductor material used for semiconductor devices. Dielectric layer 104 can be formed of a dielectric material. Example dielectric materials used in semiconductor fabrication include silicon dioxide ($SiO_2$), silicon nitride ($Si_3N_4$), high-k dielectrics (e.g., hafnium oxide ($HfO_2$), aluminum oxide ($Al_2O_3$)), low-k dielectrics (e.g., hydrogen silsesquioxane (HSQ), methylsilsesquioxane (MSQ)), silicon carbide (SiC), boron nitride (BN), and polyimide, among other insulating materials known in the art. One skilled in the art can select among known dielectric materials based on the description of the examples and embodiments herein.

Polysilicon layer 106 can include contacts 108 for at or near the edges thereof. Contacts 108 can be formed from highly doped polysilicon regions and can optionally include a low-resistance conductive material disposed thereon, such as silicide or the like. Doping of polysilicon may be a process of adding impurities to the polysilicon to increase electrical conductivity. A highly doped region of polysilicon may be a region more doped than an adjacent region (e.g., more impurities in the highly doped region than in an adjacent region).

A circuit can include wire(s) that electrically connect the electrical components. A wire may be an electrical pathway between electrical components. A node may be a point in a circuit where two or more electrical components are connected by wires. An IC can include wires formed from conductors (shown schematically), which can be electrically coupled to semiconductor substrate 102 and contacts 108. The conductors can be part of patterned conductive layer(s) (not shown) on substrate 102. The conductors can be used to apply a voltage (Vsub) to semiconductor substrate 102, a voltage (V1) to contact 108 at an edge of polysilicon layer 106, and a voltage (V2) to contact 108 at the opposite edge of polysilicon layer 106.

In such a configuration, polysilicon layer 106 can be a resistor. The voltages (V1, V2) can be the terminal voltages of the resistor. It can be shown that the resistance of polysilicon layer 106 given a constant substrate bias (e.g., Vsub = constant) can be modeled by:

$$R = R_0 * (1 + K*Vsub),$$

where $R_0$ can be the zero-volt resistance at 25°C and K can be a constant determined from device measurements of a particular implementation of the resistor (referred to as a voltage coefficient). It can be shown further that the resistance of polysilicon layer 106 as a function of its terminal voltages can be:

$$R(V1, V2) = R_0 * [1 + (K/2)*(V1 + V2)].$$

The voltage coefficient of the resistor formed by polysilicon layer 106 can be the slope of a curve of measured resistance versus a bias voltage of the resistor, where the bias voltage can be defined as the average resistor terminal voltage (V1+V2)/2 with respect to the substrate voltage (Vsub). It can be shown through measurements that such a curve is linear or substantially linear, with resistance increasing with increasing bias voltage. In such case, the voltage coefficient (K) is constant or substantially constant.

Fig. 2 is a schematic diagram depicting a circuit 200 that can be formed on a semiconductor substrate. Circuit 200 can include an operational amplifier (opamp) 202, a resistance 204, and a current source 205. An opamp may be a circuit with high gain and high input impedance. Circuits for implementing an opamp are well known in the art. An opamp can include an inverting input (-), a non-inverting input (+), and an output. A current source may be a circuit that supplies a current. Current source 205 can supply a current signal $I_{IN}(t)$. Opamp 202 and current source 205 can be formed using transistors on the semiconductor substrate. Opamp 202 can include an inverting input coupled to a node 206. Current source 205 can be coupled between node 206 and a reference voltage (Vref). A reference voltage may be a constant DC voltage (e.g., electrical ground). An output of opamp 202 can be coupled to a node 208 that provides a voltage signal Vout(t). Current signal $I_{IN}(t)$ and voltage signal Vout(t) can be analog signals. An analog signal may be a continuous-time signal representing some quantity (e.g., a voltage). Resistance 204 can be coupled between the inverting input and the output of opamp 202 (e.g., between nodes 206 and 208) to provide feedback. Resistance 204 can be formed by a series of resistors $204_1...204_N$, where N is an integer greater than one (e.g., N = 4 resistors are shown in the example). In general, a series of resistors can include two or more resistors. Each resistor $204_1...204_4$ can be formed on the semiconductor substrate as shown in Fig. 1 and described above. The non-inverting input of opamp 202 can be coupled to the reference voltage. For example, circuit 200 can be a transimpedance amplifier. A transimpedance amplifier may be a circuit that converts a current to a voltage. Current source 205 can be any circuit that supplies a current signal. For example, a transconductance amplifier may be a circuit that converts a voltage to a current and can supply a current signal. Other types of circuits that supply a current signal can also be coupled to node 206. Those skilled in the art will appreciate that current source 205 can have an equivalent circuit of a voltage source coupled to node 206 through a resistor.

In operation, the substrate can be biased using a constant voltage as described in Fig. 1 above. The voltage at node 208, Vout(t), can exhibit a non-linear error due to a non-linear change in resistance of resistors $204_1...204_4$. The change in resistance of a resistor $204_k$ (k being any integer between 1 and 4 in the example), $\Delta R$, is independent of the substrate voltage (Vsub). Rather, the change in resistance ($\Delta R$) only depends on the transient voltage difference ($\Delta V$) between the term-

inals of resistor $204_k$ and the substrate voltage (Vsub). In such case, changing the substrate voltage (Vsub) does not mitigate the non-linear error of the output voltage. The non-linear change in resistance of resistors $204_1...204_4$ can give rise to harmonics in the output voltage and undesired harmonic distortion.

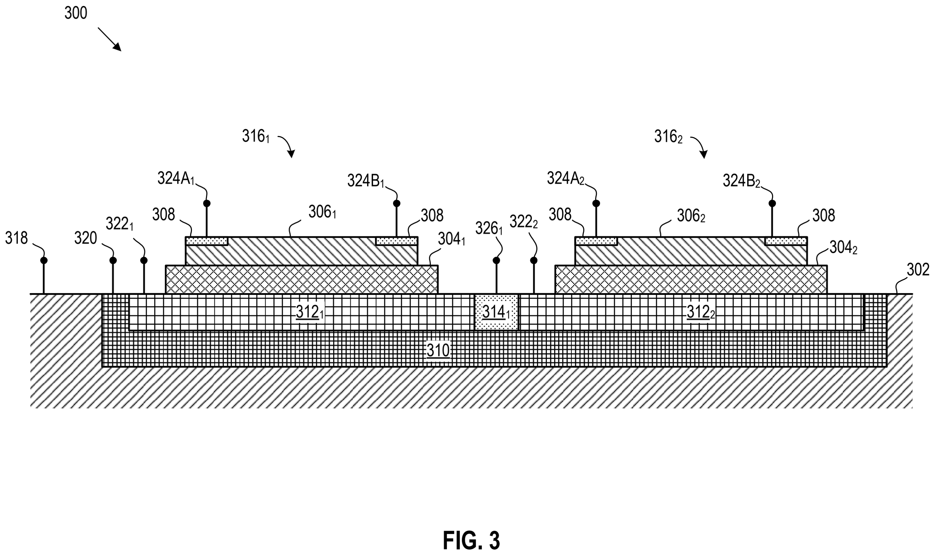

Fig. 3 is a cross-sectional view of resistors 300 according to some embodiments. Resistors 300 can be formed on an IC. In some embodiments, resistors 300 can include a polysilicon layer 306 disposed on a dielectric layer 304, which is disposed on a semiconductor substrate 302. Polysilicon layer 306 can be patterned to form polysilicon portions $306_1...306_M$, where M is an integer greater than one. In the example, polysilicon portions $306_1$ and $306_2$ are shown. Dielectric layer 304 can be patterned to form dielectric portions $304_1...304_M$, e.g., dielectric portions $304_1$ and $304_2$ are shown in the example. Polysilicon layer 306 and dielectric layer 304 can be patterned to form resistors $316_1...316_M$, e.g., resistors $316_1$ and $316_2$ are shown in the example. Each resistor $316_k$ can include a polysilicon portion $306_k$ disposed on a dielectric portion $304_k$, where k is any integer between 1 and M. Polysilicon portion $308_k$ of resistor $316_k$ can include a pair of contacts 308 disposed at or near the edges thereof. Contacts 308 can be the same or similar to contacts 108 described above.

Semiconductor substrate 302 can include a well 310. A well in a semiconductor substrate may be a localized region of the substrate doped with an impurity to create either p-type or n-type semiconductor material. Doping of a semiconductor substrate may be a process of adding impurities to the semiconductor material. The impurities improve electrical conductivity of the semiconductor material. A localized region doped to create p-type semiconductor material can be referred to as a p-well. A localized region doped to create n-type semiconductor material can be referred to as an n-well. Well 310 can be doped with an impurity to create semiconductor material of the opposite type of semiconductor substrate 302. For example, semiconductor substrate 302 can be doped to create p-type semiconductor material and well 310 can be an n-well. Well 310 can include more shallow wells formed therein. As such, well 310 can be referred to as a "deep well" (e.g., a deep n-well). A deep well may be a well formed deeper in the substrate than one or more shallow wells formed therein. Substrate 302 can include a contact 318 for providing voltage thereto. Well 310 can include a contact 320 for providing voltage thereto.

Wells $312_1...312_M$ can be formed in well 310. Each well $312_k$ can be shallower than well 310. Each well $310_k$ corresponds to a resistor $316_k$. That is, each resistor $316_k$ can be formed over a well $312_k$ within a boundary of well $312_k$. Within a boundary of a well may mean no portion of the resistor is disposed outside the well. A boundary of a well may be the periphery of the doped region forming the well. The boundaries of wells $312_1$ and $312_2$ can be disjoint (e.g., not overlapping). In some embodiments, the boundaries of wells $312_1$ and $312_2$

separated by a space. Adjacent wells 312 can be separated by a doped region 314. In the example, wells $312_1$ and $312_2$ are adjacent and separated by a doped region $314_1$. Wells 312 can be doped with an impurity to create semiconductor material of the opposite type of well 310. For example, wells 312 can be p-wells formed in an n-well. Doped regions 314 can be highly doped regions of well 310. For example, doped regions 314 can be n+ regions formed in an n-well (where "+" indicates that the doping of region 314 has a higher concentration of impurities than adjacent regions). Wells $312_1...312_M$ can include contacts $322_1...322_M$, respectively. Doped regions $314_1...314_{M-1}$ can include contacts $326_1...326_{M-1}$. Each resistor $316_k$ includes a pair of terminals $324A_k$ and $324B_k$ electrically coupled to contacts 308. Contacts 318, 320, 322, and 326, and terminals 324, can be electrically coupled to conductors formed on semiconductor substrate 302 (shown schematically).

As described in the embodiments above, resistors $316_1$ and $316_2$ can be formed from polysilicon. In other embodiments, resistors $316_1$ and $316_2$ can be formed from metal. The structure of such resistors can be the same or similar to that shown in Fig. 3, with the exception that polysilicon portions $306_1$ and $306_2$ can be replaced with metal portions. Thus, resistors $316_1$ and $316_2$ can include conductive portions, which can be polysilicon portions or metal portions.

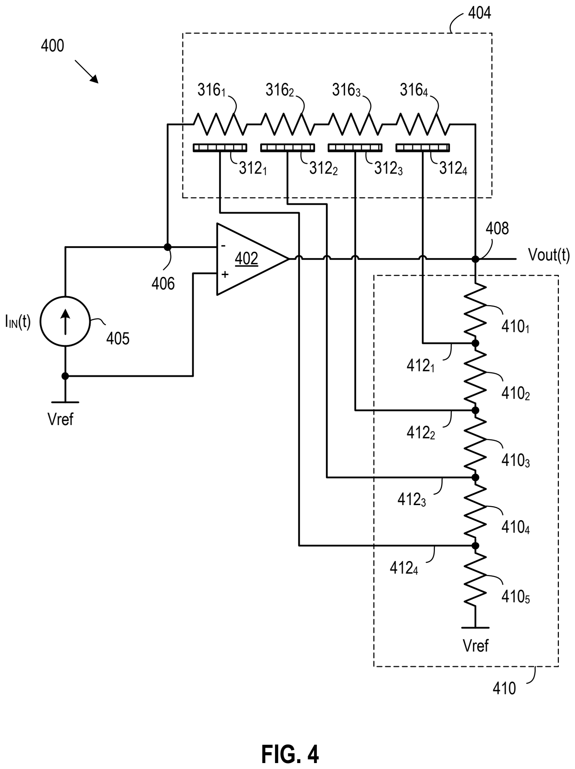

Fig. 4 is a schematic diagram of a circuit 400 that can be formed on a semiconductor substrate according to some embodiments. Circuit 400 can include a opamp 402, a resistance 404, and a current source 405. Current source 405 can supply a current signal $I_{IN}(t)$. Opamp 402 and current source 405 can be formed using transistors on the semiconductor substrate. Opamp 402 can include an inverting input coupled to a node 406. Current source 405 can be coupled between node 406 and a reference voltage (Vref). An output of opamp 402 can be coupled ot a node 408 that provides a voltage signal Vout(t). The current signal $I_{IN}(t)$ and the voltage signal Vout(t) can be analog signals. The current signal can be supplied by another circuit (e.g., transconductance amplifier or the like) (not shown). Those skilled in the art will appreciate that current source 405 can be replaced by an equivalent voltage source coupled to node 406 through a resistor. Resistance 404 can be coupled between the inverting input and the output of opamp 402 (e.g., between nodes 406 and 408) to provide feedback. Resistance 404 can be formed by a series of resistors $316_1...316_M$, where M is an integer greater than one (e.g., M = 4 resistors are shown in the example). Each resistor $316_1...316_4$ can be formed on the semiconductor substrate as shown in Fig. 3 and described above. The non-inverting input of opamp 402 can be coupled to the reference voltage (Vref). For example, circuit 400 can be a transimpedance amplifier. While resistance 404 is shown in the context of a transimpedance amplifier, it is to be understood that resistance can be used a myriad of circuit types.

As shown in Fig. 3, each resistor $316_k$ can be

formed over well $312_k$. Wells $312_1...312_4$ can have different bias voltages applied thereto through contacts $322_1...322_4$, respectively. Wells 312 and doped regions 314 can form p-n junctions (e.g., diodes). In operation, doped regions 314 can be biased at a voltage above the maximum input voltage (Vmax). As discussed below, each well $312_k$ can be biased with a voltage below the maximum input voltage (Vmax). As such, the diodes formed between wells 312 and doped regions 314 can be reverse biased so that no current flows therebetween. This allows each well $312_k$ to be biased independently. Each well $312_k$ can provide an active shield for a respective resistor. An active shield may be a shield (e.g., a well) biased with a voltage.

Circuit 400 can include a bias circuit 410. Bias circuit 410 can supply bias voltages to wells $312_1...312_4$ via nodes $412_1...412_4$, respectively. Each well $312_k$ can receive an independent bias voltage. In some embodiments, bias circuit 410 can include resistors $410_1...410_5$ coupled in series between node 408 and the reference voltage (Vref). Node $412_1$ can be between resistors $410_1$ and $410_2$; node $412_2$ can be between resistors $410_2$ and $410_3$; node $412_3$ can be between resistors $410_3$ and $410_4$; and node $412_4$ can be between resistors $410_4$ and $410_5$.

The change in resistance of a resistor $316_k$ (k being any integer between 1 and 4 in the example), ΔR, is independent of the substrate voltage (Vsub). Rather, the change in resistance (ΔR) only depends on the transient voltage (ΔV) between the terminals of resistor $316_k$ and the voltage of well $312_k$. Bias circuit 410 can bias wells 312 to minimize the transient voltage (ΔV) and tracking each well voltage towards the individual resistor terminal voltages.

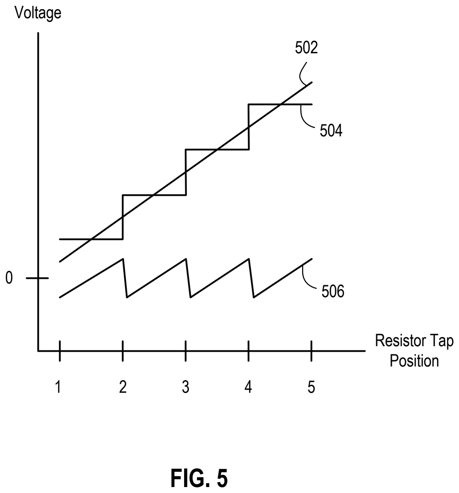

Fig. 5 is a graph qualitatively depicting voltages in circuit 400 according to some embodiments. The vertical axis of the graph represents voltage and the horizontal axis of the graph represents resistor tap position in bias circuit 410. A curve 502 can represent the voltage across resistance 404. In the example, tap 1 can be node 408; tap 2 can be between resistor $316_4$ and $316_3$; tap 3 can be between resistor $316_3$ and resistor $316_2$; tap 4 can be between resistor $316_2$ and $316_1$; and tap 5 can be node 406. A curve 504 can represent the bias voltage applied to wells $312_1...312_4$. The bias applied to well $312_1$ (between taps 4 and 5) can be a highest bias voltage and the bias applied to well $312_4$ (between taps 1 and 2) can be a lowest bias voltage. In between the bias voltage can approximate steps from one constant bias to another between the lowest bias voltage and the highest bias voltage. In this manner, the bias voltage applied to well $312_k$ tracks the voltage across its respective resistor $316_k$, which minimizes ΔV discussed above. A curve 506 can represent the voltage error at the output, which appears as a saw-tooth shape (e.g., decreasing from a max error to a min error from one terminal to another for resistor $316_1$ and then resetting to the max error for resistor $312_2$ and so on).

In the embodiments of Figs. 3-4, each resistor $316_k$ can be formed over well $312_k$, each of which can be independently biased. Resistors $316_1...316_m (2 \leq m \leq M)$ can then be coupled in series (using conductors disposed on the substrate), as shown in the example of Fig. 4. Wells 312 can provide shields for resistors 316, where each shield can be individually and independently biased. A shield may be a conductive portion. This is in contrast to where the biased substrate provides a common shield for all resistors in the series. This is also in contrast to where a biased well provides a common shield for all resistors in the series. In other embodiments, a series of resistors can have multiple shields each individually and independently biased, but each shield can accommodate more than one resistor. In other embodiments, the resistors can be in a parallel arrangement. The parallel arrangement can include one or more shields.

Returning to Fig. 3, the arrangement of wells 310, 312, and doped regions 314 can be one example arrangement that provides multiple shields for a plurality of resistors, each shield being capable of individual and independent bias. In general, multiple conductive shields can be formed under a plurality of resistors using various techniques and structures. For example, in another embodiment, wells 312 shown in Fig. 3 can be individual n-wells formed in a p-type substrate.

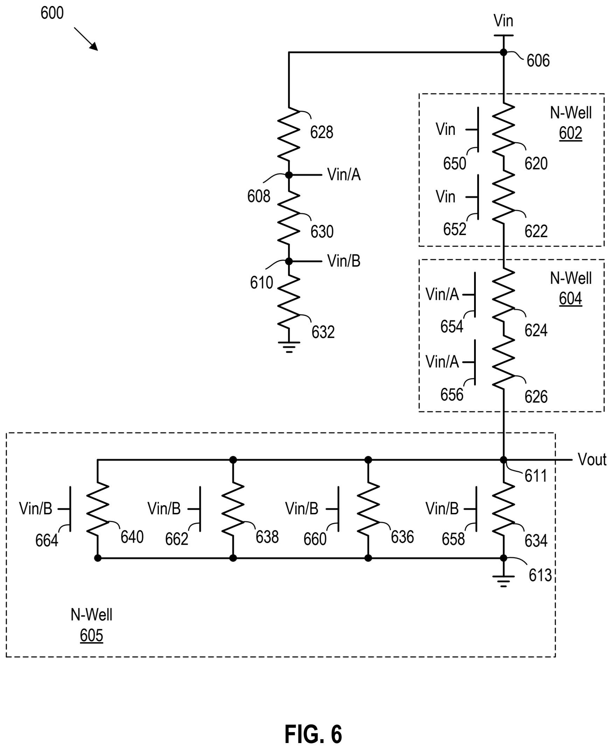

Fig. 6 is a schematic diagram depicting a circuit 600 that can be formed on an IC according to some embodiments. Circuit 600 can be a voltage divider that generates a volage Vout from a voltage Vin. A voltage divider may be a circuit that divides an input voltage into one or more output voltages less than the input voltage. The voltage divider can be formed from resistors having individual shields as described in the embodiments above. In some embodiments, circuit 600 can include resistors 620, 622, 624, and 626 coupled in series between a node 606 and a node 611. Node 606 can receive the voltage Vin (a supply voltage). Node 611 can supply the voltage Vout. Circuit 600 can include resistors 634, 636, 638, and 640 coupled in parallel between node 611 and a node 613 coupled to electrical ground. Circuit 600 can include resistors 628, 630, and 632 coupled in series between node 606 and electrical ground. Voltage divider 600 can suffer from non-linearity (deviation from ideal divide ratio) due to the voltage coefficient K of resistors 620-626, 634-640 as described above.

Resistors 620 and 622 can be formed over an n-well 602 (e.g., a deep n-well). Resistor 620 can include a shield 650 and resistor 622 includes a shield 652. Shields 650 and 652 can be formed in n-well 602 such that the shields are capable of individual and independent biasing, as discussed in embodiments above. Each of shields 650 and 652 can be biased with the voltage Vin.

Resistors 624 and 626 can be formed over an n-well 605 (e.g., a deep n-well). Resistor 624 can include a shield 654 and resistor 626 includes a shield 656. Shields 654 and 656 can be formed in n-well 604 such that the shields are capable of individual and independent biasing, as discussed in embodiments above. Each of shields 654 and 656 can be biased with the voltage Vin/A, which can be a fraction of the voltage Vin. The voltage Vin/A can be taken from node 608 between resistor 628 and resistor 630.

Resistors 634, 636, 638, and 640 can be formed over an n-well 605 (e.g., a deep n-well). Resistors 634, 636, 638, and 640 can include shields 658, 660, 662, and 664, respectively. Shields 658, 660, 662, and 664 can be formed in n-well 605 such that the shields are capable of individual and independent biasing, as discussed in embodiments above. Each of shields 658, 660, 662, and 664 can be biased with a voltage Vin/B, which can be a fraction of the voltage Vin (e.g., less than the voltage Vin/A). The voltage Vin/B can be taken from node 610 between resistor 630 and resistor 632.

In operation, shields 650, 652 can be biased (by Vin) to track the voltages applied to the terminals of resistors 620, 622. Likewise, shields 654, 656 can be biased (by Vin/A) to track the voltages applied to the terminals of resistors 624, 626. Finally, shields 658, 660, 662, and 664 can be biased (by Vin/B) to track the voltage applied to the terminals of resistors 634, 636, 638, and 640. The application of independent bias voltages on wells 602, 604, 605 effectively nulls any non-linearity or deviation from the ideal divider ratio caused by the resistor voltage coefficient K. Resistors divider 628-632 is used to generate the proper voltages for the N-well biases.

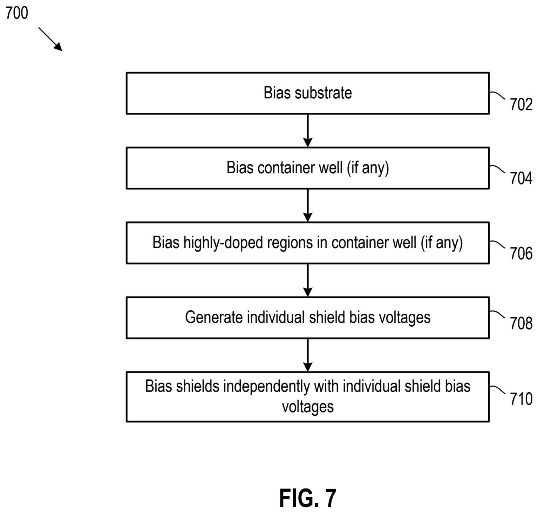

Fig. 7 is a flow diagram depicting a method 700 of biasing polysilicon resistors on an IC with individual shields according to some embodiments. Method 700 begins at step 702, where the substrate can be biased. For example, a p-type substrate can be biased with a reference voltage (e.g., electrical ground). At step 704, a container well can be biased (if present). A container well may be a well that includes other wells formed therein (e.g., a deep well). For example, Fig. 3 shows an embodiment where well 310 includes wells 312. Thus, well 310 is an example of a container well. Container well can be biased so that the p-n junction between the container well and the substrate is reversed biased. At step 706, high-doped regions in the container well can be biased (if present). For example, Fig. 3 shows an embodiment where wells 312 are separated by doped regions 314, which can be highly doped regions in well 310 (e.g., n+ regions). The highly-doped regions can be biased such that the p-n junctions between the shield wells (e.g., wells 312) and the highly doped regions (314) are reversed biased.

At step 708, individual shield bias voltages can be generated. For example, as shown in the embodiments of Figs. 4 and 6, voltage dividers can be used as bias circuits to generate individual bias voltages. Those skilled in the art will appreciate that other types of circuits can generate individual bias voltages. At step 710, the shields for the polysilicon resistors can be biased with the individual shield bias voltages. The shields can be wells formed in the semiconductor substrate (shield wells). For example, in the embodiment of Fig. 3, wells 312 can be shield wells for resistors 316. Each shield well can be biased to track the voltage difference between the resistor terminals (e.g., within some margin of error).

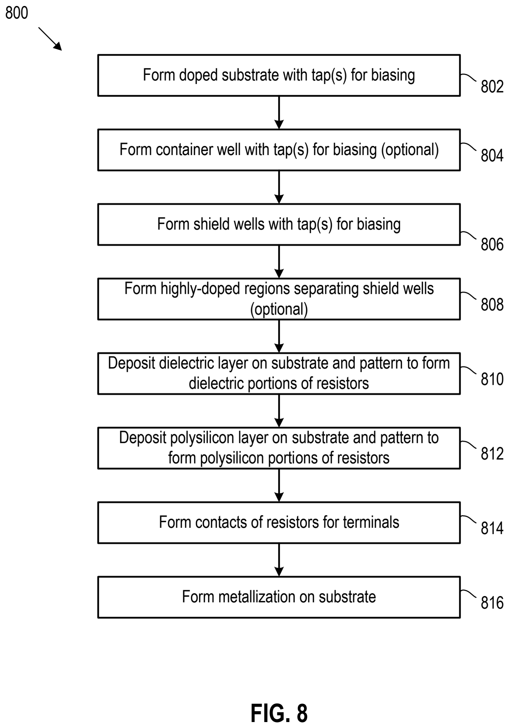

Fig. 8 is a flow diagram depicting a method 800 of fabricating polysilicon resistors of an IC according to some embodiments. Method 800 can be performed using semiconductor fabrication equipment that is well known in the art. Method 800 begins at step 802, where a doped semiconductor substrate can be formed (e.g., a p-type substrate). The substrate can be formed with taps to provide biasing contacts. At step 804, a container well can be formed in the substrate (optional). For example, in the embodiment of Fig. 3, well 310 can be formed (e.g., a deep n-well). The container well can be formed with tap(s) to provide biasing contact(s). More than one container well can be formed in step 804 (only a single container well is described for clarity).

At step 806, shield wells can be formed in the substrate. In some embodiments, the shield wells can be formed in a container well (or multiple container wells). For example, as shown in the embodiment of Fig. 3, wells 312 can be formed in well 310, where wells 312 can be shield wells for resistors 316. In other embodiments, shield wells can be formed in the substrate outside of any container wells (e.g., n-wells formed in the p-substrate). In still other embodiments, some shield wells can be formed in container well(s) and other shield wells can be formed in the substrate. At step 808, highly-doped regions can be formed in container well(s) for separating shield wells (optional). For example, in the embodiment of Fig. 3, doped regions 314 can be formed between wells 312.

At step 810, a dielectric layer can be deposited on the substrate and patterned to form dielectric portions of the resistors. For example, in the embodiment of Fig. 3, dielectric portions 304 can be formed for resistors 316. At step 812, a polysilicon layer can be deposited on the substrate and patterned to form polysilicon portions of the resistors. For example, in the embodiment of Fig. 3, polysilicon portions 306 can be formed for resistors 316. At step 814, contacts for the terminals of the resistors can be formed. For example, in the embodiment of Fig. 3, contacts 308 can be formed in and/or on the polysilicon portions 306. At step 816, metallization can be formed on the substrate that electrically connects to the substrate, container well(s) (if any), shield wells, highly-doped regions of the container well(s) (if any), and the resistor terminals. For purposes of clarity by example, such metallization is omitted from the embodiments described herein but is well-known in the art.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

The following are further embodiments of the invention:

1. An integrated circuit (IC), comprising:

a semiconductor substrate having a first well and a second well;
a first resistor disposed on the semiconductor substrate over the first well within a boundary thereof;
a second resistor disposed on the semiconductor substrate over the second well within a boundary thereof, the boundary of the second well disjoint from the boundary of the first well; and
a first contact to bias the semiconductor substrate at a first voltage, a second contact to bias the first well at a second voltage, and a third contact to bias the second well at a third voltage.

2. The IC of embodiment 1, wherein the semiconductor substrate includes a third well, and wherein the first well and the second well are disposed within a boundary of the third well.

3. The IC of embodiment 2, further comprising a highly doped region of the third well disposed between the first well and the second well.

4. The IC of embodiment 1, wherein the first resistor comprises a first conductive portion disposed on a first dielectric portion, the first conductive portion and the first dielectric portion disposed within the boundary of the first well, and wherein the second resistor comprises a second conductive portion disposed on a second dielectric portion, the second conductive portion and the second dielectric portion disposed within the boundary of the second well.

5. The IC of embodiment 1, further comprising a first circuit formed on the semiconductor substrate configured to provide the second voltage and the third voltage.

6. The IC of embodiment 5, further comprising a second circuit having an input and an output, wherein the first resistor and the second are coupled in series between the input and the output of the second circuit.

7. The IC of embodiment 6, wherein the first circuit comprises a voltage divider configured to divide voltage at the output of the second circuit to generate the second voltage and the third voltage.

8. The IC of embodiment 5, wherein the first resistor and the second resistor are coupled in series between a first node and a second node, the first node coupled to a supply voltage, the IC further comprising:

a third resistor disposed on the semiconductor substrate over a third well within a boundary thereof, the third resistor coupled between the second node and a third node, the third node coupled to electrical ground; and
a fourth contact to bias the third well at a third voltage, the first circuit configured to provide the third voltage.

9. The IC of embodiment 8, further comprising:

a fourth resistor disposed on the semiconductor substrate over a fourth well within a boundary thereof, the fourth resistor coupled between the second node and the third node; and
a fifth contact to bias the fourth well at the third voltage.

10. An apparatus, comprising:

a first circuit having an input and an output;
a resistance disposed on a semiconductor substrate, the resistance comprising first resistors coupled in series between the input and the output of the first circuit;
first wells disposed in the semiconductor substrate, each first resistor disposed within a boundary of a respective one of the first wells, the boundaries of the first wells disjoint from one another; and

a second circuit configured to generate first bias voltages and couple each first bias voltage to a respective one of the first wells.

11. The apparatus of embodiment 10, wherein the first wells are disposed within a boundary of a deep well disposed in the semiconductor substrate.

12. The apparatus of embodiment 10, wherein the first wells are separated by highly-doped regions of the deep well.

13. The apparatus of embodiment 10, wherein the second circuit comprises a voltage divider configured to divide voltage at the output of the first circuit to generate the first bias voltages.

14. The apparatus of embodiment 10, wherein the first circuit comprises an operational amplifier.

15. The apparatus of embodiment 10, wherein the input of the first circuit is coupled to a supply voltage, wherein first circuit includes a third resistor coupled between the output and electrical ground, the apparatus including:

a second well disposed in the semiconductor substrate, the third resistor disposed within a boundary of the second well;

wherein the second circuit is configured to generate a second bias voltage and couple the second bias voltage the second well.

16. The apparatus of embodiment 15, wherein the first circuit includes a fourth resistor coupled between the output and the electrical ground, the apparatus including:

a fourth well disposed on the semiconductor substrate, the fourth resistor disposed within a boundary of the fourth well;

wherein the second circuit is configured to couple the second bias voltage to the fourth well.

17. A method of fabricating an IC, comprising:

forming a semiconductor substrate having a first well and a second well;

forming a first resistor on the semiconductor substrate over the first well within a boundary thereof;

forming a second resistor on the semiconductor substrate over the second well within a boundary thereof, the boundary of the second well disjoint from the boundary of the first well; and

forming a first contact to bias the semiconductor substrate at a first voltage, a second contact to bias the first well at a second voltage, and a third contact to bias the second well at a third voltage.

18. The method of embodiment 17, further comprising forming a third well in the semiconductor substrate, wherein the first and second wells are disposed within a boundary of the third well.

19. The method of embodiment 18, further comprising forming a highly-doped region in the third well disposed between the first and second wells.

20. The method of embodiment 17, wherein the first resistor comprises a first conductor portion disposed on a first dielectric portion, the first conductor portion and the first dielectric portion disposed within the boundary of the first well, and wherein the second resistor comprises a second conductor portion disposed on a second dielectric portion, the second conductor portion and the second dielectric portion disposed within the boundary of the second well.

**Claims**

1. An integrated circuit (IC), comprising:

a semiconductor substrate having a first well and a second well;
a first resistor disposed on the semiconductor substrate over the first well within a boundary thereof;
a second resistor disposed on the semiconductor substrate over the second well within a boundary thereof, the boundary of the second well disjoint from the boundary of the first well; and
a first contact to bias the semiconductor substrate at a first voltage, a second contact to bias the first well at a second voltage, and a third contact to bias the second well at a third voltage.

2. The IC of claim 1, wherein the semiconductor substrate includes a third well, and wherein the first well and the second well are disposed within a boundary of the third well,

in particular,
the IC further comprising a highly doped region of the third well disposed between the first well and the second well.

3. The IC of one of the previous claims, wherein the first resistor comprises a first conductive portion disposed on a first dielectric portion, the first conductive portion and the first dielectric portion disposed within the boundary of the first well, and wherein the second resistor comprises a second conductive portion disposed on a second dielectric portion, the second conductive portion and the second dielectric portion disposed within the boundary of the second well.

4. The IC of one of the previous claims, further comprising a first circuit formed on the semiconductor substrate configured to provide the second voltage and the third voltage.

5. The IC of claim 4, further comprising a second circuit having an input and an output, wherein the first resistor and the second are coupled in series between the input and the output of the second circuit,

   in particular,
   wherein the first circuit comprises a voltage divider configured to divide voltage at the output of the second circuit to generate the second voltage and the third voltage.

6. The IC of claim 4, wherein the first resistor and the second resistor are coupled in series between a first node and a second node, the first node coupled to a supply voltage, the IC further comprising:

   a third resistor disposed on the semiconductor substrate over a third well within a boundary thereof, the third resistor coupled between the second node and a third node, the third node coupled to electrical ground; and
   a fourth contact to bias the third well at a third voltage, the first circuit configured to provide the third voltage.

7. The IC of claim 6, further comprising:

   a fourth resistor disposed on the semiconductor substrate over a fourth well within a boundary thereof, the fourth resistor coupled between the second node and the third node; and
   a fifth contact to bias the fourth well at the third voltage.

8. An apparatus, comprising:

   a first circuit having an input and an output;
   a resistance disposed on a semiconductor substrate, the resistance comprising first resistors coupled in series between the input and the output of the first circuit;
   first wells disposed in the semiconductor substrate, each first resistor disposed within a boundary of a respective one of the first wells, the boundaries of the first wells disjoint from one another; and
   a second circuit configured to generate first bias voltages and couple each first bias voltage to a respective one of the first wells.

9. The apparatus of claim 8, wherein the first wells are disposed within a boundary of a deep well disposed in the semiconductor substrate
   and/or
   wherein the first wells are separated by highly-doped regions of the deep well.

10. The apparatus of claim 8 or 9, wherein the second circuit comprises a voltage divider configured to divide voltage at the output of the first circuit to generate the first bias voltages
    and/or
    wherein the first circuit comprises an operational amplifier.

11. The apparatus of one of claims 8 to 10, wherein the input of the first circuit is coupled to a supply voltage, wherein first circuit includes a third resistor coupled between the output and electrical ground, the apparatus including:

    a second well disposed in the semiconductor substrate, the third resistor disposed within a boundary of the second well;
    wherein the second circuit is configured to generate a second bias voltage and couple the second bias voltage the second well.

12. The apparatus of claim 11, wherein the first circuit includes a fourth resistor coupled between the output and the electrical ground, the apparatus including:

    a fourth well disposed on the semiconductor substrate, the fourth resistor disposed within a boundary of the fourth well;
    wherein the second circuit is configured to couple the second bias voltage to the fourth well.

13. A method of fabricating an IC, comprising:

    forming a semiconductor substrate having a first well and a second well;
    forming a first resistor on the semiconductor substrate over the first well within a boundary thereof;
    forming a second resistor on the semiconductor substrate over the second well within a boundary thereof, the boundary of the second well disjoint from the boundary of the first well; and
    forming a first contact to bias the semiconductor substrate at a first voltage, a second contact to bias the first well at a second voltage, and a third contact to bias the second well at a third voltage.

14. The method of claim 13, further comprising forming a third well in the semiconductor substrate, wherein the first and second wells are disposed within a boundary of the third well,

> in particular,
> the method further comprising forming a highly-doped region in the third well disposed between the first and second wells.

15. The method of claim 13 or 14, wherein the first resistor comprises a first conductor portion disposed on a first dielectric portion, the first conductor portion and the first dielectric portion disposed within the boundary of the first well, and wherein the second resistor comprises a second conductor portion disposed on a second dielectric portion, the second conductor portion and the second dielectric portion disposed within the boundary of the second well.

**FIG. 1**

**FIG. 2**

**FIG. 3**

**FIG. 4**

**FIG. 5**

FIG. 6

700

```
┌─────────────────────────────────────┐
│           Bias substrate            │──── 702
└─────────────────────────────────────┘
                   │
                   ▼
┌─────────────────────────────────────┐
│       Bias container well (if any)  │──── 704
└─────────────────────────────────────┘
                   │
                   ▼
┌─────────────────────────────────────┐
│ Bias highly-doped regions in container well (if any) │──── 706
└─────────────────────────────────────┘
                   │
                   ▼
┌─────────────────────────────────────┐
│   Generate individual shield bias voltages   │──── 708
└─────────────────────────────────────┘
                   │
                   ▼
┌─────────────────────────────────────┐
│ Bias shields independently with individual shield bias │──── 710
│              voltages               │
└─────────────────────────────────────┘
```

# FIG. 7

800

```
┌─────────────────────────────────────────────┐
│   Form doped substrate with tap(s) for biasing │ ─── 802
└─────────────────────────────────────────────┘
                      │
                      ▼
┌─────────────────────────────────────────────────────┐
│ Form container well with tap(s) for biasing (optional) │ ─── 804
└─────────────────────────────────────────────────────┘
                      │
                      ▼
┌─────────────────────────────────────────────┐
│    Form shield wells with tap(s) for biasing    │ ─── 806
└─────────────────────────────────────────────┘
                      │
                      ▼
┌─────────────────────────────────────────────┐
│  Form highly-doped regions separating shield wells │ ─── 808
│                   (optional)                    │
└─────────────────────────────────────────────┘
                      │
                      ▼
┌───────────────────────────────────────────────────┐
│ Deposit dielectric layer on substrate and pattern to form │ ─── 810
│        dielectric portions of resistors             │
└───────────────────────────────────────────────────┘
                      │
                      ▼
┌───────────────────────────────────────────────────┐
│  Deposit polysilicon layer on substrate and pattern to  │ ─── 812
│        form polysilicon portions of resistors        │
└───────────────────────────────────────────────────┘
                      │
                      ▼
┌─────────────────────────────────────────────┐
│      Form contacts of resistors for terminals     │ ─── 814
└─────────────────────────────────────────────┘
                      │
                      ▼
┌─────────────────────────────────────────────┐
│        Form metallization on substrate          │ ─── 816
└─────────────────────────────────────────────┘
```

**FIG. 8**

Europäisches
Patentamt
European
Patent Office
Office européen
des brevets

# EUROPEAN SEARCH REPORT

**Application Number**

EP 25 20 5935

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/313692 A1 (SUTARDJA SEHAT [US] ET AL) 13 December 2012 (2012-12-13) | 1,3,4, 6-8, 11-15 | INV. H10D1/00 H10D1/47 |
| Y | * paragraphs [0034], [0039], [0051]; figure 4D * | 2,5,9,10 | H10D84/00 |
| Y | US 2021/043720 A1 (LI DING [CN] ET AL) 11 February 2021 (2021-02-11) * paragraph [0144]; figure 11 * | 2,9 | |
| Y | US 2006/118908 A1 (ERICKSON SEAN C [US] ET AL) 8 June 2006 (2006-06-08) * paragraph [0017]; figure 1A * | 2,9 | |
| Y | JP 2017 038135 A (ASAHI KASEI DENSHI KK) 16 February 2017 (2017-02-16) | 5,10 | |
| A | * paragraph [0093]; figure 12 * | 6,7,11, 12 | |
| Y | US 2018/269839 A1 (MEHRABI ARASH [US] ET AL) 20 September 2018 (2018-09-20) | 5,10 | TECHNICAL FIELDS SEARCHED (IPC) |
| A | * paragraph [0048]; figures 5,6 * | 6,7,11, 12 | H10D |

The present search report has been drawn up for all claims

| Place of search | Date of completion of the search | Examiner |
|---|---|---|
| Munich | 27 February 2026 | Günay Demirkol, Anil |

## ANNEX TO THE EUROPEAN SEARCH REPORT
## ON EUROPEAN PATENT APPLICATION NO.

EP 25 20 5935

This annex lists the patent family members relating to the patent documents cited in the above-mentioned European search report.
The members are as contained in the European Patent Office EDP file on
The European Patent Office is in no way liable for these particulars which are merely given for the purpose of information.

27-02-2026

| Patent document cited in search report | | Publication date | Patent family member(s) | | Publication date |
|---|---|---|---|---|---|
| US 2012313692 | A1 | 13-12-2012 | CN | 103718294 A | 09-04-2014 |
| | | | EP | 2718972 A1 | 16-04-2014 |
| | | | TW | 201250986 A | 16-12-2012 |
| | | | US | 2012313692 A1 | 13-12-2012 |
| | | | WO | 2012170148 A1 | 13-12-2012 |
| US 2021043720 | A1 | 11-02-2021 | CN | 110400791 A | 01-11-2019 |
| | | | CN | 114400216 A | 26-04-2022 |
| | | | US | 2021043720 A1 | 11-02-2021 |
| | | | WO | 2019205585 A1 | 31-10-2019 |
| US 2006118908 | A1 | 08-06-2006 | NONE | | |
| JP 2017038135 | A | 16-02-2017 | NONE | | |
| US 2018269839 | A1 | 20-09-2018 | US | 2017187336 A1 | 29-06-2017 |
| | | | US | 2018269839 A1 | 20-09-2018 |

EPO FORM P0459

For more details about this annex : see Official Journal of the European Patent Office, No. 12/82